# EUROPÄISCHE PATENTSCHRIFT

(11) **EP 0 801 448 B1**
(45) Veröffentlichungstag und Bekanntmachung des Hinweises auf die Patenterteilung: **31.10.2001**
(21) Anmeldenummer: 97104308.8
(22) Anmeldetag: 13.03.1997
(51) Int. Cl.: H01S 5/022, G01S 7/48

(54) **Laserabordnung zur Erzeugung eines Haupt- und eines Referenzlichtstrahls**
Laser device for generating a master lightray and a reference lightray
Dispositif laser pour générer un faisceau principal de lumière et un faisceau de référence

(30) Priorität: 12.04.1996 DE 19614526
(43) Veröffentlichungstag der Anmeldung: 15.10.1997
(73) Patentinhaber: SICK AG, 79183 Waldkirch (DE)
(72) Erfinder: Damm, Hartmut, 79331 Teningen (DE); Wetteborn, Hainer, 79183 Waldkirch (DE)
(74) Vertreter: Finsterwald, Martin, Dr.

(56) Entgegenhaltungen:
- EP-A- 0 467 137
- DE-C- 4 109 844
- US-A- 4 817 109
- PATENT ABSTRACTS OF JAPAN vol. 013, no. 248 (E-770), 9. Juni 1989 & JP 01 049291 A (NEC CORP), 23. Februar 1989
- SCHWARTE R: "PERFORMANCE CAPABILITIES OF LASER RANGING SENSORS" PROCEEDINGS OF THE WORKSHOP ON SPACE LASER APPLICATIONS & TECHNOLOG (SPLAT), LES DIABLERETS, MAR. 25 - 30, 1984, 25. März 1984, Seiten 61-67, XP000041253 EUROPEAN SPACE AGENCY

## Beschreibung

Die Erfindung betrifft eine Laseranordnung mit einer auf einem Substrat angeordneten Laserdiode zur Erzeugung eines aus einer Hauptöffnung austretenden Hauptlichtstrahls.

Beim Einsatz derartiger Laseranordnungen in bestimmten Anwendungsgebieten, beispielsweise bei auf dem Prinzip der Lichtlaufzeitmessung basierenden Entfernungsmessern ist es nötig, aus der Laseranordnung zusätzlich zum Hauptlichtstrahl auch noch einen Referenzlichtstrahl abzuleiten.

Üblicherweise wird dies dadurch bewerkstelligt, daß der Hauptlichtstrahl in eine Lichtleitfaser eingekoppelt wird, welche mit einem Y-Koppler versehen ist, der die ihm zugeführte Lichtmenge in einen Hauptlichtstrahl und einen Referenzlichtstrahl aufteilt.

Der Einsatz eines derartigen Y-Kopplers ist auf nachteilige Weise mit zusätzlichem Aufwand verbunden, welcher eine Erhöhung der Herstellungskosten bedingt und zudem aufgrund des benötigten zusätzlichen separaten Bauteils den Platzbedarf einer entsprechenden Anordnung erhöht.

Eine Aufgabe der Erfindung besteht darin, eine Laseranordnung der eingangs genannten Art derart auszubilden, daß die Auskopplung sowohl eines Haupt- als auch Referenzlichtstrahls ohne den Einsatz eines Y-Kopplers möglich wird.

Erfindungsgemäß wird diese Aufgabe dadurch gelöst, daß die Laserdiode zumindest auf mehreren Seiten von Material hoher Reflektivität umgeben ist, welches derart angeordnet ist, daß ein nicht zur Bildung des Hauptlichtstrahls verwendeter Anteil des von der Laserdiode erzeugten Lichts unter Modenmischung mehrfach reflektiert bzw. gestreut wird, und daß entfernt von der Hauptöffnung eine den Durchtritt eines definierten Referenzlichtanteils gestattende Referenzöffnung vorgesehen ist.

Erfindungsgemäß wird also ein Teil des von der Laserdiode erzeugten Lichts bereits in der Laseranordnung vom Hauptlichtstrahl abgetrennt und zur Bildung eines Referenzlichtstrahls verwendet. Zu diesem Zweck kann die Laserdiode beispielsweise auf einer Seite, vorzugsweise auf ihrer Rückseite mit einer zusätzlichen Lichtaustrittsöffnung versehen sein, aus der die für die Bildung des Referenzlichtstrahls benötigte Lichtmenge austreten kann. Der genannte Lichtanteil wird dann nach dem Austritt aus der Laserdiode von dem erfindungsgemäß vorgesehenen reflektierenden Material mehrfach reflektiert bzw. gestreut, wodurch eine Modenmischung auftritt. Das derart reflektierte bzw. gestreute Licht tritt dann durch die Referenzöffnung aus der Laseranordnung aus und bildet dabei den gewünschten Referenzlichtstrahl.

An einer erfindungsgemäßen Laseranordnung kann somit beispielsweise sowohl eine Lichtleitfaser für den Hauptlichtstrahl als auch eine Lichtleitfaser für den Referenzlichtstrahl direkt - ohne Verwendung eines Y-Kopplers - angeschlossen werden, wodurch sich sowohl der zu betreibende wirtschaftliche Aufwand als auch der erforderliche Platzbedarf auf vorteilhafte Weise verringern läßt.

Bei einer bevorzugten Ausführungsform der Erfindung wird die Referenzöffnung der Laseranordnung außerhalb des direkten Abstrahlbereichs der Laserdiode angeordnet, so daß verhindert wird, daß von der Laserdiode abgestrahltes Licht direkt zur Referenzöffnung gelangt. Auf diese Weise wird sichergestellt, daß nur reflektiertes bzw. gestreutes Licht durch die Referenzöffnung gelangt, wodurch die gewünschte Modenmischung mit Sicherheit erreicht wird. Die Wirkungsweise dieser bevorzugten Ausführungsform der Erfindung entspricht einer Ulbricht-Kugel, wobei die in einer Ulbricht-Kugel üblicherweise vorhandene Blende im vorliegenden Fall durch die erwähnte Relativanordnung von Laserdiode und Referenzöffnung ersetzt wird. Die Funktion der Blende bei der Ulbricht-Kugel besteht nämlich darin, zu verhindern, daß das Licht direkt von der Lichtquelle zur Austrittsöffnung gelangt. Entsprechendes wird bei der erfindungsgemäßen Anordnung dadurch erreicht, daß auf die erwähnte Weise die Laserdiode und die Referenzöffnung relativ so zueinander angeordnet werden, daß kein Lichtstrahl direkt von der Laserdiode zur Referenzöffnung gelangen kann.

Im Gegensatz zur Referenzöffnung ist es bezüglich der Hauptöffnung natürlich sinnvoll, diese innerhalb des direkten Abstrahlbereiches der Laserdiode anzuordnen, da der Hauptlichtstrahl direkt ohne Reflexion bzw. Streuung gebildet werden soll.

Das die Laserdiode erfindungsgemäß umgebende Material kann eine Reflektivität größer 0,8, insbesondere größer 0,9 und bevorzugt zwischen 0,96 und 0,99 aufweisen.

Von Vorteil ist es, wenn das Substrat ebenfalls eine entsprechend hohe Reflektivität besitzt.

Bei einer weiteren vorteilhaften Ausführungsform der Erfindung wird auf der dem Substrat abgewandten Seite der Laserdiode eine zusätzliche Schicht hoher Reflektivität vorgesehen. Dabei können sich das reflektierende Substrat sowie die gegenüberliegende zusätzliche reflektierende Schicht an der Rückseite der Laserdiode deutlich über deren Länge hinaus erstrecken und auf diese Weise einen Reflexions- und Streukanal für auf der Rückseite der Laserdiode austretendes Licht bilden.

Vorzugsweise bestehen das Substrat und/oder die zusätzliche reflektierende Schicht aus Keramik, die insbesondere eine im wesentlichen weiße Farbe aufweist und somit gut reflektiert.

Von Vorteil ist es ferner, wenn die gesamte erfindungsgemäße Anordnung in einem innenseitig reflektierenden Gehäuse untergebracht ist, da hierdurch der erwünschte Reflexions- und Streueffekt bezüglich des Referenzlichtstrahls zusätzlich unterstützt wird.

Das Gehäuse kann beispielsweise als Hybridgehäuse ausgebildet werden, welches vorzugsweise auf seiner Innenseite eine goldene Farbe aufweist.

Die in der Laseranordnung vorhandene Laserdiode kann auf übliche Weise auf ihrer Vorder- und/oder Rückseite verspiegelt sein, wobei es sinnvoll ist, auf der verspiegelten Rückseite eine kleine Iichtaustrittsöffnung für denjenigen Lichtanteil vorzusehen, der zur Bildung des Referenzstrahles verwendet werden soll.

Der Hauptlichtstrahl wird vorzugsweise von zwischen 90 % und 99 %, insbesondere von ungefähr 96 % des von der Laserdiode erzeugten Lichts gebildet. Der Referenzlichtstrahl wird vorzugsweise von einem Anteil zwischen 1 % und 10 %, insbesondere von ungefähr 4 % des von der Laserdiode erzeugten Lichts gebildet.

Bei einer bevorzugten Ausführungsform der Erfindung besitzt der Referenzlichtstrahl einen Abstrahlwinkel zwischen 30° und 50°, insbesondere einen Abstrahlwinkel von ungefähr 40°.

Bei einer weiteren vorteilhaften Ausführungsform der Erfindung ist an der Haupt- und/oder Referenzöffnung eine der jeweiligen Öffnung zugeordnete Lichtleitfaser angeordnet, in die das durch die jeweilige öffnung austretende Licht eingekoppelt wird.

Auf dem die Laserdiode tragenden Substrat kann in üblicher Weise eine Ansteuerschaltung für die Laserdiode angeordnet werden.

Weitere bevorzugte Ausführungsformen der Erfindung sind in den Unteransprüchen angegeben.

Die Erfindung wird nachfolgend anhand von Ausführungsbeispielen unter Bezugnahme auf die Zeichnungen beschrieben; in diesen zeigen:
- Figur 1: eine schematisierte Querschnittsdarstellung durch eine erfindungsgemäße Laseranordnung und
- Figur 2: ein Prinzipschaubild eines Entfernungsmessers unter Verwendung einer erfindungsgemäßen Laseranordnung.

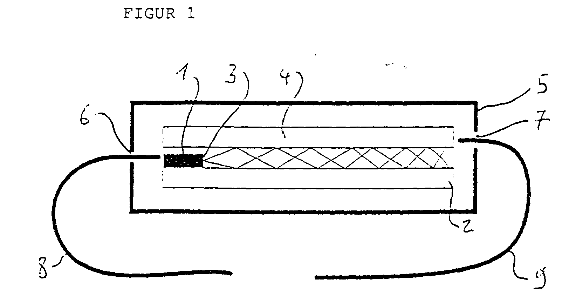

Figur 1 zeigt eine Laserdiode 1, die mit dem Randbereich eines Keramiksubstrats 2 verbunden ist, wobei sich das Keramiksubstrat 2 an der Rückseite 3 der Laserdiode 1 deutlich über deren Länge hinaus erstreckt. Die Längserstreckung des Keramiksubstrats 2 beträgt dabei ungefähr das 8-fache der Längserstreckung der Laserdiode 1.

An der dem Keramiksubstrat 2 abgewandten Seite der Laserdiode 1 ist eine Deckkeramik-Schicht 4 vorgesehen, deren Abmessungen im wesentlichen den Abmessungen des Keramiksubstrats 2 entsprechen und die sich parallel zum Keramiksubstrat 2 erstreckt.

Die Anordnung von Laserdiode 1, Keramiksubstrat 2 und Deckkeramik 4 entspricht somit einer Sandwich-Bauweise, bei der die Laserdiode L zwischen dem Keramiksubstrat 2 und der Deckkeramik 4 in deren Randbereich angeordnet ist.

Derjenige Bereich des Keramiksubstrats 2 und der Deckkeramik 4, der sich jeweils über die Längserstreckung der Laserdiode 1 hinauserstreckt, bildet einen die erwünschte Modenmischen bewirkenden Reflexions- bzw. Streukörper für auf der Rückseite 3 der Laserdiode 1 austretendes Licht. Zu diesem Zweck sind Keramiksubstrat 2 und Deckkeramik 4 reflektierend ausgebildet, insbesondere besitzen sie eine weiße Farbe.

Die aus Laserdiode L, Keramiksubstrat 2 und Deckkeramik 4 bestehende Anordnung ist in einem Hybridgehäuse 5 untergebracht, welches die genannte Anordnung weitgehend vollständig umschließt. Die Innenseite des Hybridgehäuses 5 ist reflektierend, insbesondere goldfarben ausgebildet, um auf diese Weise den für die Referenzlichtauskopplung erwünschten Effekt der Modenmischung zu unterstützen.

Das Hybridgehäuse 5 weist eine Hauptöffnung 6 auf, welche derart mit der Laserdiode 1 ausgerichtet ist, daß der von der Laserdiode 1 ausgehende Hauptlichtstrahl direkt durch die Hauptöffnung 6 treten kann.

Weiterhin ist das Hybridgehäuse 5 mit einer Referenzöffnung 7 versehen, durch die das Referenzlicht ausgekoppelt wird.

Die Referenzöffnung 7 ist dabei außerhalb des direkten Abstrahlbereiches der Laserdiode 1 angeordnet, so daß grundsätzlich nur reflektiertes bzw. gestreutes Licht durch die Referenzöffnung 7 gelangen kann. Bei dem in Figur 1 dargestellten Ausführungsbeispiel verhindert die Deckkeramik 4, daß ein Lichtstrahl direkt von der Rückseite 3 der Laserdiode 1 zur Referenzöffnung 7 gelangen kann.

In die Hauptöffnung 6 ist eine Sendelichtleitfaser 8 eingeführt, welche den Hauptlichtstrahl aus der dargestellten Laseranordnung herausführt. In analoger Weise ist in die Referenzöffnung 7 eine Referenzlichtleitfaser 9 eingeführt.

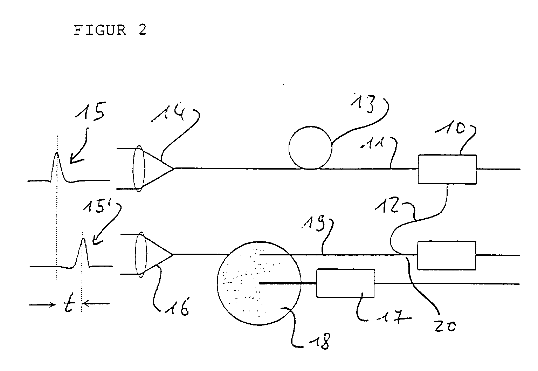

Figur 2 zeigt das Prinzipschaubild eines Entfernungsmessers unter Verwendung einer erfindungsgemäßen Laseranordnung.

Der Sender 10 kann beispielsweise entsprechend Figur 1 mit einer Sendelichtleitfaser 11 und einer Referenzlichtleitfaser 12 auf erfindungsgemäße Art und Weise gekoppelt werden. Das über die Sendelichtleitfaser 11 laufende Licht erfährt bei 13 eine Verzögerung bzw. Modenmischung und gelangt dann zu einer Sendeoptik 14, über die letztendlich ein vom Sender 10 erzeugter Hauptlichtimpuls 15 abgestrahlt wird.

Nach Verstreichen einer Signallaufzeit t gelangt der von einem geeignetem Objekt reflektierte Hauptlichtimpuls 15' auf eine Empfangsoptik 16.

Der empfangene Lichtimpuls wird anschließend über eine mittels eines Motors 17 antreibbare Graukeilscheibe 18 abgeschwächt, um die Amplitude des empfangenen Signals auf ein erforderliches Maß zu reduzieren.

Der auf diese Weise abgeschwächte empfangene Lichtimpuls wird in eine Empfangslichtleitfaser 19 eingekoppelt. Diese Empfangslichtleitfaser 19 ist mit einem Faserkoppler 20 ausgerüstet, über den die Referenzlichtleitfaser 12 mit der Empfangslichtleitfaser 19 verbunden ist.

Am Ausgang des Faserkopplers 20 liegen somit sowohl das empfangene Lichtsignal als auch das Referenzlichtsignal an.

Der Ausgang des Faserkopplers 20 ist mit dem Eingang eines Empfängers verbunden, welcher das empfangene Lichtsignal als auch das Referenzlichtsignal in elektrische Signale zum Zweck der weiteren Auswertung umwandelt.

Die Erfindung ist n cht auf das in Verbindung mit Figur 2 beschriebene Anmeldungsbeispiel beschränkt, es lassen sich eine Vielzahl von anderen Anwendungsfällen denken.

## Patentansprüche

1. Laseranordnung mit einer auf einem Substrat (2) angeordneten Laserdiode (1) zur Erzeugung eines aus einer Hauptöffnung (6) austretenden Hauptlichtstrahls,
**dadurch gekennzeichnet,**
**daß** die Laserdiode (1) zumindest auf mehreren Seiten von Material hoher Reflektivität umgeben ist, welches derart angeordnet ist, daß ein nicht zur Bildung des Hauptlichtstrahls verwendeter Anteil des von der Laserdiode (1) erzeugten Lichts zur Bildung eines Referenzlichtanteils unter Modenmischung mehrfach reflektiert bzw. gestreut wird, und daß entfernt von der Hauptöffnung (6) eine den Durchtritt eines definierten Referenzlichtanteils gestattende Referenzöffnung (7) vorgesehen ist.

2. Laseranordnung nach Anspruch 1,
**dadurch gekennzeichnet,**
**daß** die Referenzöffnung (7) außerhalb des direkten Abstrahlbereichs der Laserdiode (1) angeordnet ist, so daß nur reflektiertes bzw. gestreutes Licht durch die Referenzöffnung (7) gelangen kann, und/oder daß die Hauptöffnung (6) innerhalb des direkten Abstrahlbereichs der Laserdiode (1) angeordnet ist.

3. Laseranordnung nach einem der vorhergehenden Ansprüche,
**dadurch gekennzeichnet,**
**daß** das die Laserdiode (1) umgebende Material eine Reflektivität größer 0,8, insbesondere größer 0,9 und bevorzugt zwischen 0,96 und 0,99 besitzt, und/oder daß das Substrat (2) ebenfalls eine hohe Reflektivität besitzt.

4. Laseranordnung nach einem der vorhergehenden Ansprüche,
**dadurch gekennzeichnet,**
**daß** auf der dem Substrat (2) abgewandten Seite der Laserdiode (1) eine zusätzliche Schicht (4) hoher Reflektivität angeordnet ist, wobei sich insbesondere das reflektierende Substrat (2) sowie die gegenüberliegende zusätzliche Schicht (4) an der Rückseite (3) der Laserdiode (1) deutlich über deren Länge hinaus erstrecken und so einen Reflexions- und Streukanal für auf der Rückseite (3) der Laserdiode (1) austretendes Licht bilden.

5. Laseranordnung nach einem der vorhergehenden Ansprüche,
**dadurch gekennzeichnet,**
**daß** das Substrat (2) aus einem Keramiksubstrat besteht.

6. Laseranordnung nach einem der Ansprüche 4 oder 5,
**dadurch gekennzeichnet,**
**daß** die zusätzliche Schicht (4) von einer Deckkeramik gebildet ist, wobei insbesondere Substratkeramik (2) und Deckkeramik (4) eine in etwa weiße Farbe aufweisen.

7. Laseranordnung nach einem der vorhergehenden Ansprüche,
**dadurch gekennzeichnet,**
**daß** die Anordnung in einem innenseitig reflektierenden Gehäuse (5) untergebracht ist, wobei insbesondere das Gehäuse (5) als Hybridgehäuse ausgebildet ist und/oder das Gehäuse (5) auf seiner Innenseite eine goldene Farbe besitzt.

8. Laseranordnung nach einem der vorhergehenden Ansprüche,
**dadurch gekennzeichnet,**
**daß** die Laserdiode (1) auf ihrer Vorder- und/oder Rückseite (3) verspiegelt ist, und/oder daß der Hauptlichtstrahl von zwischen 90% und 99%, vorzugsweise von ungefähr 96% des von der Laserdiode (1) erzeugten Lichts gebildet ist, und/oder daß der Referenzlichtstrahl von zwischen 1% und 10%, vorzugsweise von ungefähr 4% des von der Laserdiode (1) erzeugten Lichts gebildet ist.

9. Laseranordnung nach einem der vorhergehenden Ansprüche,
**dadurch gekennzeichnet,**
**daß** der Referenzlichtstrahl einen Abstrahlwinkel zwischen 30° und 50°, insbesondere von ungefähr 40° besitzt, und/oder daß an der Haupt- und/oder Referenzöffnung (6, 7) eine Lichtleitfaser (8, 9, 11, 12) angeordnet ist, in die das durch die jeweilige Öffnung (6, 7) tretende Licht eingekoppelt wird, und/oder daß auf dem Substrat (2) eine Ansteuerschaltung für die Laserdiode (1) angeordnet ist.

10. Vorrichtung zur Entfernungsmessung mittels Lichtpuls-Laufzeitverfahren, mit einer Meßstrecke (11, 13, 19) und einer Referenzstrecke (12),
**dadurch gekennzeichnet,**
**daß** eine Laseranordnung (10) nach einem der Ansprüche 1 bis 19 vorgesehen ist, wobei die Meßstrecke (11, 13, 19) über die Hauptöffnung (6) und die Referenzstrecke (12) über die Referenzöffnung (7) der Laseranordnung mit Licht beaufschlagt ist.

## Claims

1. A laser arrangement having a laser diode (1) arranged at a substrate (2)for the generation of a main light beam exiting a main aperture (6), **characterised in that** the laser diode (1) is surrounded at least at a plurality of sides by material of high reflectivity which is arranged such that a component of the light generated by the laser diode (1) and not used to form the main light beam is reflected or scattered multiple times under mode mixing to form a reference light component; and **in that** a reference aperture (7) permitting the transmission of a defined reference light component is provided remote from the main aperture (6).

2. A laser arrangement in accordance with claim 1, **characterised in that** the reference aperture (7) is arranged outside the direct transmission region of the laser diode (1) so that only reflected or scattered light can pass through the reference aperture (7); and/or **in that** the main aperture (6) is arranged within the direct transmission region of the laser diode (1).

3. A laser arrangement in accordance with any one of the preceding claims, **characterised in that** the material surrounding the laser diode (1) has a reflectivity greater than 0.8, in particular greater than 0.9, and preferably between 0.96 and 0.99; and/or **in that** the substrate (2) likewise has a high reflectivity.

4. A laser arrangement in accordance with any one of the preceding claims, **characterised in that** an additional layer (4) of high reflecting power is arranged at the side of the laser diode (1) remote from the substrate (2), with in particular the reflecting substrate (2) and the opposite additional layer (4) extending clearly beyond the length of the laser diode (1) at the rear side (3) thereof and so forming a reflection and scattering passage for light exiting at the rear side (3) of the laser diode (1).

5. A laser arrangement in accordance with any one of the preceding claims, **characterised in that** the substrate (2) consists of a ceramic substrate.

6. A laser arrangement in accordance with one of the claims 4 or 5, **characterised in that** the additional layer (4) is formed by a covering ceramic material, with in particular the substrate ceramic material (2) and the covering ceramic material (4) having a roughly white colour.

7. A laser arrangement in accordance with any one of the preceding claims, **characterised in that** the arrangement is accommodated in an inwardly reflecting housing (5), with in particular the housing (5) being formed as a hybrid housing; and/or **in that** the housing (5) has a golden colour at its inside.

8. A laser arrangement in accordance with any one of the preceding claims, **characterised in that** the laser diode (1) is mirror coated at its front and/or rear side (3); and/or **in that** the main light beam is formed by between 90% and 99%, preferably by approximately 96%, of the light generated by the laser diode (1); and/or **in that** the reference light beam is formed by between 1% and 10%, preferably by approximately 4%, of the light generated by the laser diode (1).

9. A laser arrangement in accordance with any one of the preceding claims, **characterised in that** the reference light beam has a transmission angle of between 30° and 50°, in particular of approximately 40°; and/or **in that** an optical fibre (8, 9, 11, 12) is arranged at the main aperture and/or reference aperture (6, 7) and the light incident to the respective aperture (6, 7) is coupled thereinto; and/or **in that** a control circuit for the laser diode (1) is arranged at the substrate (2).

10. An apparatus for range finding by means of a light impulse transit method having a measuring distance (11, 13, 19) and a reference distance (12), **characterised in that** a laser arrangement (10) in accordance with any one of the claims 1 to 9 is provided, wherein the measuring distance (11, 13, 19) is exposed to light via the main aperture (6) and the reference distance (12) is exposed to light via the reference aperture (7) of the laser arrangement.

## Revendications

1. Agencement à laser, comprenant une diode laser (1) agencée sur un substrat (2) afin de produire un faisceau lumineux principal sortant hors d'une ouverture principale (6),
**caractérisé en ce que** la diode laser (1) est entourée au moins sur plusieurs côtés avec un matériau de forte réflectivité, agencé de telle façon qu'une proportion, qui n'est pas utilisée pour former le faisceau lumineux principal, de la lumière produite par la diode laser (1) est réfléchie plusieurs fois, ou respectivement diffractée plusieurs fois pour former une part lumineuse de référence avec mélange de modes, et **en ce qu'**il est prévu une ouverture de référence (7) éloignée de l'ouverture principale (6) permettant la traversée d'une part lumineuse de référence définie.

2. Agencement à laser selon la revendication 1,
**caractérisé en ce que** l'ouverture de référence (7) est agencée à l'extérieur de la région de rayonnement directe de la diode laser (1), de sorte que seule la lumière réfléchie ou diffractée peut parvenir à travers l'ouverture de référence (7), et/ou **en ce que** l'ouverture principale (6) est agencée à l'intérieur de la région de rayonnement directe de la diode laser (1).

3. Agencement à laser selon l'une des revendications précédentes,
**caractérisé en ce que** le matériau qui entoure la diode laser (1) possède une réflectivité supérieure à 0,8, en particulier supérieure à 0,9 et de préférence entre 0,96 et 0,99, et/en ce que le substrat (2) possède également une forte réflectivité.

4. Agencement à laser selon l'une des revendications précédentes,
**caractérisé en ce que** sur le côté de la diode laser (1) détourné du substrat (2) est agencée une couche supplémentaire (4) de forte réflectivité, et **en ce qu'**en particulier le substrat réflecteur (2) ainsi que la couche supplémentaire opposée (4) sur la face postérieure (3) du laser (1) s'étendent nettement au-delà de sa longueur, et forment ainsi un canal de réfection et de diffraction pour la lumière sortant sur le côté postérieur (3) de la diode de laser (1).

5. Agencement laser selon l'une des revendications précédentes,
**caractérisé en ce que** le substrat (2) est un substrat en céramique.

6. Agencement à laser selon l'une ou l'autre des revendications 4 et 5,
**caractérisé en ce que** la couche supplémentaire (4) est formée par un revêtement en céramique, et **en ce qu'**en particulier la céramique du substrat (2) et la céramique de revêtement (4) présentent une couleur approximativement blanche.

7. Agencement à laser selon l'une des revendications précédentes,
**caractérisé en ce que** l'agencement est logé dans un boîtier (5) réflecteur du côté intérieur, et ce qu'en particulier le boîtier (5) est réalisé sous forme de boîtier hybride, et/ou **en ce que** le boîtier (5) possède sur son côté intérieur une couleur dorée.

8. Agencement à laser selon l'une des revendications précédentes,
**caractérisé en ce que** la diode laser (1) est rendue réfléchissante sur son côté antérieur et/ou son côté postérieur (3), et/en ce que le faisceau de lumière principal est constitué par une proportion entre 90 et 99 %, et de préférence environ 96 % de la lumière produite par la diode laser (1), et/ou **en ce que** le faisceau de lumière de référence est constitué par une proportion entre 1 et 10 %, de préférence environ 4 % de la lumière produite par la diode laser (1).

9. Agencement à laser selon l'une des revendications précédentes,
**caractérisé en ce que** le faisceau de lumière lumineux de référence possède un angle de rayonnement entre 30° et 50°, en particulier environ 40°, et/ou **en ce qu'**une fibre guide d'ondes (8, 9, 11, 12) est agencée au niveau de l'ouverture principale et/ou de l'ouverture de référence (6, 7), dans laquelle la lumière traversant l'ouverture respective (6, 7) est couplée, et/ou **en ce qu'**un circuit de pilotage pour la diode laser (1) est agencé sur le substrat (2).

10. Appareil pour la mesure de distance au moyen d'un procédé à impulsions de lumière et temps de parcours, comprenant un trajet de mesure (11, 13, 19) et un trajet de référence (12),
**caractérisé en ce qu'**il est prévu un agencement à laser (10) selon l'une des revendications 1 à 9, et **en ce que** le trajet de mesure (11, 13, 19) est parcouru par de la lumière provenant de l'ouverture principale (6) et le trajet de référence (12) est parcouru par de la lumière provenant de l'ouverture de référence (7) de l'agencement à laser.
